# EUROPEAN PATENT APPLICATION

(11) **EP 2 579 305 A1**
(43) Date of publication of application: **10.04.2013**
(21) Application number: 11786055.1
(22) Date of filing: 21.05.2011
(51) Int. Cl.: H01L 23/36

(54) **HEAT RADIATION DISSIPATION FILM STRUCTURE AND METHOD FOR MAKING THE SAME**

(30) Priority: 25.05.2010 CN 201010181772
(71) Applicant: JingDeZhen Fared Technology Co., Ltd, Ceramic Industrial Park Jingdezhen City, 333000 Jiangxi (CN)
(72) Inventor: CHEN, Jeong-Shiun, Jiangxi 333000 (CN)
(74) Representative: Gee, Steven William
(86) International application number: PCT/CN2011/074468
(87) International publication number: WO 2011/147283

(57) **Abstract**

Disclosed are a heat radiation dissipation film structure and a method of making the same. The heat radiation dissipation film structure includes a substrate which is electrically insulated and a heat radiation dissipation film disposed on the substrate. The difference between the thermal expansion coefficients of the substrate and the heat radiation dissipation film is not greater than 0.1%. The heat radiation dissipation film contains the crystal of at least one metal and nonmetal with a specific microscopic surface structure which is formed by spraying and coating the heated mixture onto the substrate under high pressure. The heat radiation from the heat radiation dissipation film is directed from the interface of the heat radiation dissipation film and the substrate towards the substrate.

## Description

### BACKGROUND OF THE INVENTION

### 1. Field of the Invention

The present invention generally relates to a heat radiation dissipation film structure and a method of making the same, and more specifically to a heat radiation dissipation film structure including a heat radiation dissipation film for enhancing the cooling effect through heat radiation.

### 2. The Prior Arts

In general, mechanic devices or electric appliances may deteriorate or even fail to work due to overheating. Additionally, the lifetime is thus reduced. Consequently, various heat dissipation devices or mechanisms are needed to prevent the temperature of the working device from exceeding the allowable temperature.

For example, internal combustion engine is operated by the explosion force generated by igniting the high pressured gasoline or Diesel oil within a closed chamber. A vehicle is driven to move by the mechanic power output from the internal combustion engine through a gear chain or a driving mechanism. The internal temperature of the working engine is extremely high and the engine may easily overheat and hence the engine does not work normally without certain appropriate heat dissipation mechanism. In the worst condition, the engine may explode. Therefore, a lot of cooling fins are provided on the outer surface of the engine to improve the cooling effect by increasing the cooling surface area. Alternatively, a heat sink is connected to the engine to thermally conduct the heat generated by the engine.

The conventional method of enhancing the cooling effect by thermal conduction in the above-mentioned has been widely applied to the LED (light emitting diode) industry for the sake of environmental protection and power saving purposes. Theoretically, the intensity of light emitted by the LED is proportional to the current conduction. However, the light emitting efficient and the lifetime of the LED are greatly influenced by the working temperature. Thus, the light of the LED can be increased just by decreasing the temperature of the LED. That is, when the intensity of light per unit area for the LED is increased and the cost of LED using less material is reduced. In particular, the LED has been widely used recently such that the problem of heat dissipation for the LED becomes more critical.

However, one of the shortcomings in the prior arts is that the heat is propagated from the hotter side to the cooler side and the heat flow is proportional to the effective thermal area. As a result, it is needed to increase the surface area of the heat dissipation device and the cost is increased such that the final product is too heavy and it is inconvenient to use. For example, the LED is about 10 times as cost as a traditional lamp bulb and thus people have little interest to use the LED instead of the lamp bulb. Besides, as the LED with 2 W attains up to 135°C, the additional heat dissipation device may help the LED reduce to only 125°C or 115°C, and it is still too high. Therefore, it is strongly desired to provide a new heat radiation dissipation film structure and a method of manufacturing the same without increasing the surface area for thermal dissipation so as to achieve more effective thermal dissipation by using heat radiation instead of thermal conduction and thus overcome the above problems existing in the prior arts.

### SUMMARY OF THE INVENTION

The primary objective of the present invention is to provide a heat radiation dissipation film structure, which includes a substrate that is electrically insulated and a heat radiation dissipation film disposed on the substrate. The difference between the thermal expansion coefficients of the substrate and the heat radiation dissipation film is not greater than 0.1%.

The heat radiation dissipation film has a first surface and a second surface, the first surface has a specific microscopic surface structure, and the second surface is in contact with the substrate. The heat from the heat radiation dissipation film is propagated by heat radiation towards the second surface. Therefore, it is possible that the temperature of an external object separated from the substrate is not lower than the temperature of the heat radiation dissipation film.

The heat radiation dissipation film is made from a mixture of metal and nonmetal consisting of a metal compound and a nonmetal compound. The metal compound comprises at least one of silver, copper, tin, aluminum, titanium, iron and antimony, or at least one alloy of silver, copper, tin, aluminum, titanium, iron and antimony, or at least one oxide or halide of silver, copper, tin, aluminum, titanium, iron and antimony. And the nonmetal compound comprises at least one oxide, nitride or inorganic salt compound of at least one of boron and carbon.

Another objective of the present invention is to provide a method of manufacturing a heat radiation dissipation film structure, comprising the steps of preparing a metal compound, a nonmetal compound and at least one solvent, pressuring a mixture of metal and nonmetal to form a pressurized mixture, heating the substrate, spraying and coating the pressurized mixture onto the heated substrate such that the heat radiation dissipation film is formed on the heated substrate through crystal growth by the pressurized mixture, and cooling the substrate and the heat radiation dissipation film to form the heat radiation dissipation film structure consisting of the substrate and the heat radiation dissipation film.

### BRIEF DESCRIPTION OF THE DRAWINGS

The present invention can be understood in more detail by reading the subsequent detailed description in conjunction with the examples and references made to the accompanying drawings, wherein:

FIG. 1 is a view showing a heat radiation dissipation film structure according to the present invention;

FIG. 2 is a view showing a heat radiation spectroscopic diagram of the heat radiation dissipation film employed in the heat radiation dissipation film structure according to the present invention; and

FIG. 3 shows a flow diagram of the method of manufacturing the heat radiation dissipation film structure according to the present invention.

### DETAILED DESCRIPTION OF THE PREFERRED EMBODIMENT

The present invention may be embodied in various forms and the details of the preferred embodiments of the present invention will be described in the subsequent content with reference to the accompanying drawings. The drawings (not to scale) show and depict only the preferred embodiments of the invention and shall not be considered as limitations to the scope of the present invention. Modifications of the shape of the present invention shall too be considered to be within the spirit of the present invention.

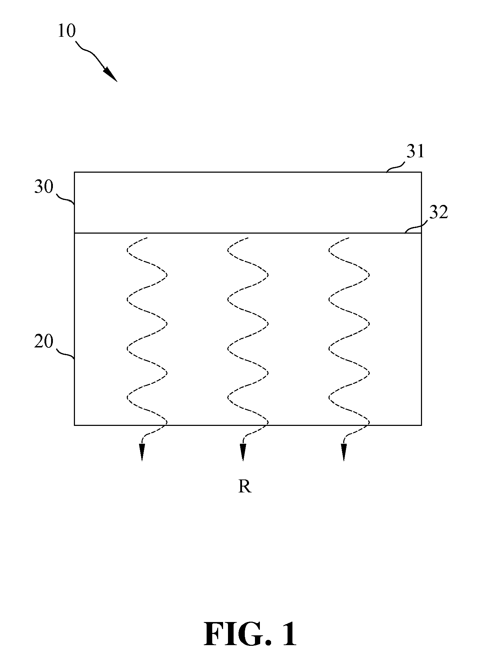

FIG. 1 illustrates the heat radiation dissipation film structure according to the present invention. As shown in FIG. 1, the heat radiation dissipation film structure 10 of the present invention includes a substrate 20 which is electrically insulated and a heat radiation dissipation film 30 disposed on the substrate 20. The substrate 20 has the first thermal expansion coefficient, and the heat radiation dissipation film 30 has the second thermal expansion coefficient. More specifically, the difference between the first thermal expansion coefficient and the second thermal expansion coefficient is not greater than 0.1%.

The heat radiation dissipation film 30 has a first surface 31 and a second surface 32 opposite to the first surface 31. The second surface 32 is in contact with the substrate 20, as shown in FIG. 1.

The heat radiation dissipation film 30 is made from a mixture of metal and nonmetal, comprising a metal compound and a nonmetal compound. The metal compound consists of at least one of silver, copper, tin, aluminum, titanium, iron and antimony, or at least one alloy of silver, copper, tin, aluminum, titanium, iron and antimony, or at least one oxide or halide of silver, copper, tin, aluminum, titanium, iron and antimony. The nonmetal compound consists of an oxide, nitride or inorganic salt of at least one of boron and carbon. For example, the mixture of metal and nonmetal may comprise halide of titanium antimony and carbonate.

The first surface 31 of the heat radiation dissipation film 30 has a specific microscopic surface structure. Specifically, the microscopic structure contains crystal with a grain size between 2 nm and 1 µm, and the crystal preferably consists of a global or polyhedral grain. For example, the crystal is pyramid octahedral crystal.

In addition to thermal conduction, the above heat radiation dissipation film 30 may primarily propagate the heat towards the substrate 20 from the second surface by heat radiation so as to enhance the effect of thermal dissipation.

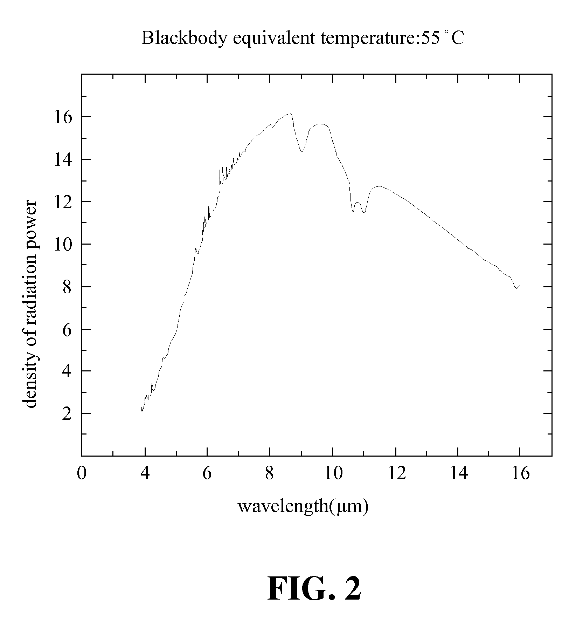

In general, the mechanism of thermal dissipation for the heat radiation dissipation film 30 of the heat radiation dissipation film structure 10 of the present invention strongly depends on the thickness and the composition of the heat radiation dissipation film 30. It is believed that the crystal formed in the heat radiation dissipation film 30 can generate strong lattice resonance in the range of heat radiation such as infrared, and particularly far infrared. As shown in FIG. 2, the heat radiation spectroscopic diagram of the heat radiation dissipation film 30 of the heat radiation dissipation film structure according to the present invention clearly illustrates that the primary bandwidth of heat radiation for the equivalent black body at 55°C is between 4 µm to 16 µm, which is recognized as far infrared. Of course, it should be noted that what shown in FIG. 2 is just an illustrative example of the heat radiation spectrum of the heat radiation dissipation film for clearly describing the present invention, and thus it is not intended to limit the scope of the present invention.

Owing to the heat radiation as the primary mechanism of thermal dissipation for the heat radiation dissipation film structure of the present invention, no medium is needed to propagate the heat and it is totally different from the conventional scheme for heat dissipation by using thermal conduction and convection. Therefore, the efficiency of heat dissipation of the heat radiation dissipation film structure 10 of the present invention is much higher than that of the conventional heat sink.

For example, when a heat source (not shown) is provided on the heat radiation dissipation film 30 in FIG. 1, at steady state, the heat source, the substrate 20 and the heat radiation dissipation film 30 may keep at higher temperature or a thermal gradient from higher to lower temperature upwards is established because the heat generated by the heat source may propagate towards the substrate 20 under the heat radiation dissipation film 30. That is, the temperature of the heat source is higher than that of the heat radiation dissipation film 30 and the temperature of the heat radiation dissipation film 30 is higher than that of the substrate 20. At this time, if a first external object (not shown) is located at one position above the heat radiation dissipation film 30, a second external object (not shown) is located at another position under the substrate 20, and the distance between the first external object and the heat radiation dissipation film 30 is the same as the distance between the second external object and the substrate 20, it is measured that the temperature of the second external object is higher than that of the first external object and simultaneously higher than that of the heat source. Theoretically, the heat should not transfer from lower to high temperature just by thermal conduction and convention, and it apparently conforms that the heat dissipation mechanism in the present invention is heat radiation instead of thermal conduction or convention.

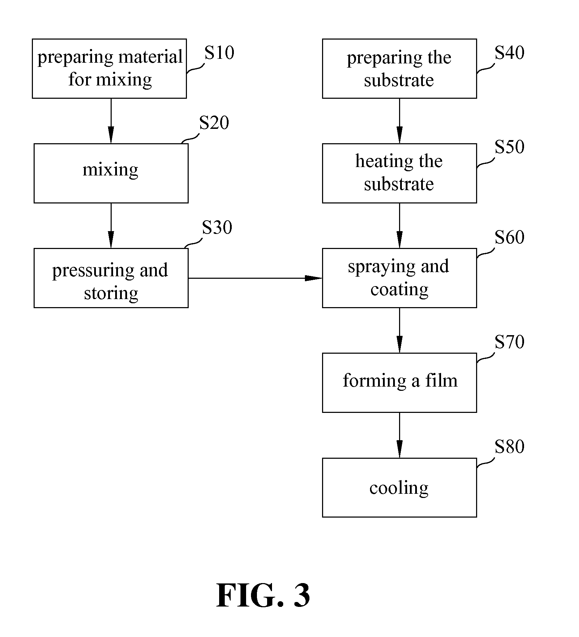

FIG. 3 illustrates the flow diagram of the method of manufacturing a heat radiation dissipation film structure according to the present invention. As shown in FIG. 3, the method of the present invention comprises the steps S10 to S80 sequentially performed to manufacture the heat radiation dissipation film structure.

First, the method of the present invention begins at the step S10 to prepare a metal compound, a nonmetal compound and at least one solvent. The metal compound and the nonmetal compound are the same as what is mentioned above in FIG. 1 and the relevant description is omitted herein for the sake of brevity. The at least solvent comprises at least one of water, alcohol compound, ketone and inorganic acid. For example, methyl alcohol is selected as the at least solvent.

Next, in the step S20, the metal compound, the nonmetal compound and the at least one solvent prepared in the step S10 are mixed thoroughly to form a mixture of metal and nonmetal. The mixture of metal and nonmetal is compressed up to a first amount of pressure to form a pressurized mixture which is stored in some appropriate closed container in the step S30.

The step S40 is simultaneously performed with the step S30 to prepare the substrate 20.

Specifically, in the step S40, the substrate 20 is prepared in such a manner to be electrically insulated and has the first thermal expansion coefficient. Next, the substrate 20 is heated to the first temperature that is much higher than a normal room temperature.

The step S60 is performed to spray and coat the pressurized mixture in the step S30 onto the heated substrate 20, and then the pressurized mixture on the substrate 20 forms the heat radiation dissipation film 30 in the step S70 because the solvent in the pressurized mixture is evaporated and only the solid components remain. The heat radiation dissipation film 30 has the second thermal expansion coefficient such that the difference between the first thermal expansion coefficient and the second thermal expansion coefficient is not greater than 0.1 %. It should be noted that the allowable difference between these two thermal expansion coefficients is one of the key factors to form the heat radiation dissipation film 30 on the substrate 20. The surface of the heat radiation dissipation film 30 has the microscopic structure as mentioned in the above description. Finally, the step S80 is performed to cool the substrate 20 down and the heat radiation dissipation film 30 to form the heat radiation dissipation film structure, as shown in FIG. 1.

More specifically, the first amount of pressure in the step S30 is preferably between 0.2 MPa and 10 MPa, and the first temperature in the step S50 is between 250°C and 1300°C. Additionally, a nozzle with an appropriate shape can be used in the step S60 to spray and coat the pressurized mixture onto the substrate 20, but it is just an illustrative example and not intended to limit the scope of the present invention.

Therefore, one aspect of the present invention is that the heat radiation dissipation film structure is provided to greatly enhance heat dissipation by the way of heat radiation rather than thermal conduction or convention. Also, the heat radiation dissipation film structure is suitably applied to a variety of heat sources to achieve high efficiency of heat dissipation and reduce the temperature of the heat source.

Another aspect is that the heat flow of heat dissipation for the heat radiation dissipation film structure is specifically directed towards the substrate from the heat radiation dissipation film on the substrate.

Although the present invention has been described with reference to the preferred embodiments, it will be understood that the invention is not limited to the details described thereof. Various substitutions and modifications have been suggested in the foregoing description, and others will occur to those of ordinary skill in the art. Therefore, all such substitutions and modifications are intended to be embraced within the scope of the invention as defined in the appended claims.

## Claims

1. A heat radiation dissipation film structure, comprising:
a substrate electrically insulated, having a first thermal expansion coefficient; and
a heat radiation dissipation film disposed on the substrate, having a first surface and a second surface opposing to the first surface and in contact with the substrate,
wherein the heat radiation dissipation film has a second thermal expansion coefficient, the heat radiation dissipation film is made from a mixture of metal and nonmetal, the first surface has a microscopic structure, a heat radiation from the heat radiation dissipation film is directed from an interface of the heat radiation dissipation film and the substrate towards the second surface, a difference between the first thermal expansion coefficient and the second thermal expansion coefficient is not greater than 0.1 %, the mixture of metal and nonmetal comprises a metal compound and a nonmetal compound, and the metal compound comprises at least one of silver, copper, tin, aluminum, titanium, iron and antimony, or at least one alloy of silver, copper, tin, aluminum, titanium, iron and antimony, or at least one oxide or halide of silver, copper, tin, aluminum, titanium, iron and antimony.

2. The heat radiation dissipation film structure as claimed in claim 1, wherein the nonmetal compound comprises an oxide, nitride or inorganic salt of at least one of boron and carbon, and the microscopic structure of the heat radiation dissipation film includes crystal with a grain size between 2 nm and 1 µm.

3. The heat radiation dissipation film structure as claimed in claim 2, wherein the crystal is a global or polyhedral grain.

4. A method of making a heat radiation dissipation film structure, comprising:
preparing a metal compound, a nonmetal compound and at least one solvent, wherein the metal compound comprises at least one of silver, copper, tin, aluminum, titanium, iron and antimony, or at least one alloy of silver, copper, tin, aluminum, titanium, iron and antimony, or at least one oxide or halide of silver, copper, tin, aluminum, titanium, iron and antimony;
mixing the metal compound, the nonmetal compound and the at least one solvent to form a mixture of metal and nonmetal;
pressuring the mixture of metal and nonmetal up to a first amount of pressure to form a pressurized mixture, and storing the pressurized mixture;
preparing a substrate which is electrically insulated and has a first thermal expansion coefficient;
heating the substrate to a first temperature;
spraying and coating the pressurized mixture onto the heated substrate such that a heat radiation dissipation film is formed on the heated substrate through crystal growth by the pressurized mixture; and
cooling the substrate and the heat radiation dissipation film on the substrate to a room temperature so as to form the heat radiation dissipation film structure comprising the substrate and the heat radiation dissipation film,
wherein the heat radiation dissipation film has a second thermal expansion coefficient, and a difference between the first thermal expansion coefficient of the substrate and the second thermal expansion coefficient of the heat radiation dissipation film is not greater than 0.1 %.

5. The method as claimed in claim 4, wherein the nonmetal compound consists of an oxide, nitride or inorganic salt of at least one of boron and carbon.

6. The method as claimed in claim 4, wherein the at least one solvent consists of at least one of water, alcohol compound, ketone and inorganic acid.

7. The method as claimed in claim 4, wherein the first amount of pressure is between 0.2 MPa and 10 MPa, and the first temperature is between 250°C and 1300°C.

8. The method as claimed in claim 4, wherein the heat radiation dissipation film has a microscopic structure of the heat radiation dissipation film containing crystal with a grain size between 2 nm and 1 µm.

9. The method as claimed in claim 8, wherein the crystal consists of a global or polyhedral grain.
